# EUROPEAN PATENT APPLICATION

(11) **EP 4 741 994 A1**
(43) Date of publication of application: **13.05.2026**
(21) Application number: 24211045.0
(22) Date of filing: 06.11.2024
(51) Int. Cl.: G06F 1/18, H05K 3/22, H05K 3/30, G01R 31/28, H05K 5/00, H05K 13/04, H04M 1/02

(54) **METHOD FOR ASSEMBLING AN EMBEDDED COMPUTER SYSTEM POWERED BY A REPURPOSED MOTHERBOARD**

(71) Applicant: Swarn SRL, 1420 Braine-l'Alleud (BE)
(72) Inventor: FERON, Jean-Brieuc, 1420 Braine-l'Alleud (BE)
(74) Representative: Dennemeyer & Associates S.A.

(57) **Abstract**

This disclosure pertains to a method for repurposing a motherboard (100) to assemble an embedded computer system (1000, 2000, 3000, 4000), the method comprising the steps of:
- (S1) extracting the motherboard (100) from an electronic device (10 ; 12, 14, 16);
- (S2) directly connecting mechanically and electrically the extracted motherboard (100) to a carrier board (200), wherein the carrier board (200) provides electrical power and at least one motherboard interface to the extracted motherboard (100),
- (S3) providing, via the carrier board (200), at least one standardized interface to the extracted motherboard (100), thereby enabling an external communication of the extracted motherboard (100), called repurposed motherboard (150), with electrical components external to the repurposed motherboard (150), and
- (S4a, S4b, S4c) integrating the repurposed motherboard (150) into the embedded computer system (1000, 2000, 3000, 4000).

## Description

### Technical field

The present disclosure relates to embedded systems, particularly to a method and apparatus for repurposing the motherboards of smart devices in microcomputers, such as smartphone motherboards, smartwatch motherboards, portable speakers motherboards, and the likes. In particular, the present disclosure pertains to a method for repurposing a motherboard to assemble an embedded computer system.

### Background

It is known that the disposal of electronic waste, also called e-waste, particularly from mobile devices like smartphones, handheld GPS or smart watches, has become a significant global challenge. As new smartphone models are rapidly released, older devices are often discarded, contributing to environmental degradation. E-waste management efforts, such as recycling, typically focus on breaking down devices into raw materials, recovering basic components like metals and plastics. However, these processes are energy-intensive and fail to make efficient use of the fully functional electronic components that could be repurposed.

Recycling processes break down discarded devices into raw materials, disregarding the potential for reusing functional components like motherboards and their processors, memory or communication controllers that remain adapted to carry out other tasks or less demanding applications. Thus, recycling fails to capture the full potential of the embedded systems still present in these devices, and valuable processing units are lost.

A method for reusing electronic computing components is described, for example, in US patent No. US9253893B1, which discusses improving the recycling of used mobile devices by selectively removing modular components, such as displays. Specifically, it is described how to manually remove a modular display from a logic board without the use of tools, and then physically mating the display to a different device, allowing the display to function in the new device.

However, this method is unsuitable for creating entirely new computing systems. The complexity of ensuring compatibility between components often results in fragmented, bulky and unreliable systems that lack the integrated functionality of a complete computing unit. Furthermore, these methods often require significant hardware modifications and specialized socket connections, which restrict their scalability and adaptability for a wider range of applications.

In other words, while the existing approaches do extend the lifecycle of some components, they are limited by the requirement to select specific parts, which must be compatible with the new hardware via dedicated interfaces.

These approaches therefore lack the flexibility to reuse entire system boards as independent computing units, which would offer more sustainable solutions. Additionally, existing methods typically retain the original smartphone operating system, restricting the ability of future users to fully control and customize repurposed components for new applications, if any.

Consequently, there is a need for new solutions that allow for the upcycling of electronic devices, such as entire smartphones, extending the lifecycle of these components and reducing the environmental impact associated with their disposal. There is also a clear need for methods and systems that eliminate the dependence of components based on specific models of existing electronic devices and/or smartphones. Furthermore, the lack of full control over the operating systems is also a challenge for enabling greater flexibility for parties aiming at repurposing hardware in view of different applications or aiming at using secure computing systems benefitting of security updates.

### Summary

To address this or these drawbacks, it is proposed according to a first aspect of the present disclosure a method for repurposing a motherboard to assemble an embedded computer system, the method comprising the steps of:
- extracting the motherboard from an electronic device,
- directly connecting mechanically and electrically the extracted motherboard to a carrier board, wherein the carrier board provides electrical power and at least one motherboard interface to the extracted motherboard,
- providing, with the carrier board, to the extracted motherboard at least one standardized interface, said at least one standardized interface being configured to adapt the at least one motherboard interface into a standardized power and communication interface, said standardized power and communication interface enabling an external communication of the extracted motherboard to electrical components that are external to the extracted motherboard, the extracted motherboard comprising the standardized power and communication interface being called a repurposed motherboard, and
assembling the embedded computer system by integrating the repurposed motherboard and the carrier board into said embedded computer system.

In a possible embodiment, the at least one interface comprises a power interface and/or a communication interface

Herein, a standardized interface comprises another power interface and/or another communication interface which are similar to the power and/or communication interfaces used in embedded computer systems, such as conventional or non-circular embedded computer systems.

Herein, providing the extracted motherboard with the at least one standardized interface leads to a modification of the latter. However, this modification merely adapts the electrical circuits, the power interface(s), the communication interface(s) and/or software components installer on the motherboard, so that they can interact with the integrated components of the motherboard, or other external components.

Herein, when the extracted motherboard is adapted to comprise the standardized power and communication interface enabling the external communication of the extracted modified motherboard to electrical components that are external to the adapted motherboard, said adapted motherboard is called repurposed motherboard.

Herein, an embedded computer system is a combination of computer hardware and software designed for a specific function. Embedded systems might also function within a larger system. These systems can be programmable or have a fixed functionality. Embedded systems are used today to control numerous devices. For example, they're used in industrial machines, consumer electronics, agricultural and processing industry devices, automobiles, medical devices, cameras, digital watches, household appliances, airplanes, vending machines, toys and mobile devices.

Herein, a module is a functional unit, either hardware or software, designed to perform a specific task or set of tasks within a larger system. A module may interface with other components or systems to extend functionality and can operate independently or in conjunction with other modules. It may include its own control logic, processing capabilities, memory, or communication interfaces, depending on the application. A module can be replaceable, upgradable, or configurable to adapt to different operational requirements.

Examples of hardware modules in smartphones, smartwatches, and Bluetooth speakers are camera modules, display modules, GPS receivers, wireless communication modules (such as Bluetooth, Wi-Fi, or NFC), battery management systems, microphone and speaker units, vibration motors, and biometric sensors (such as fingerprint or heart rate sensors). Examples of software modules in these devices are mobile operating system components, communication protocol stacks (such as Bluetooth, Wi-Fi, or 5G), user interface frameworks, security encryption algorithms, media playback software, voice recognition modules, and sensor data processing algorithms.

Examples of protocols and interfaces relevant to data communication for the embodiments which are herein described are provided by the OSI model. The OSI model defines a reference for structuring data exchange between systems, allowing modularity, interoperability, and layered troubleshooting of networking issues.

According to the OSI model, the "Layer 1" is the physical layer, responsible for transmitting raw data streams over a physical medium, including managing electrical signals, data rates, and connectors that define the physical interface between devices.

By extracting the motherboard, the communication capabilities of the physical layer of the OSI model of the original electronic device are broken, which prevents data from streaming over the physical transport medium while keeping the upper layers of the OSI model functionally isolated and intact. Therefore, connecting the repurposed motherboard to a carrier board restores this physical layer, re-enabling the complete data link and network functionality of the embedded system and enabling communication capabilities that extend across other OSI model layers, such as the data link layer, called "Layer 2" for framing and error detection, and the network layer, called "Layer 3" for routing and addressing.

Herein, a direct mechanical and electrical connection of the extracted motherboard to the carrier board means that the connections can be carried out directly board to board (motherboard to the carrier board and vice-versa), carried out via cables or with wires or direct contact between a pin, such as a pogo pin, and a contact surface on the opposite board.

Advantageously, repurposing prevents the production of new electronic devices, known to be highly polluting processes.

In a possible embodiment, the electronic device is selected among a phone, a smartphone, a watch, a smartwatch, headphones, a speaker, a Bluetooth speaker, a tablet, a laptop, a desktop computer, a television, a camera, a wearable tracker, a gaming console, a set-top box, a voice-activated smart assistant device, such as a smart speaker, or an intelligent personal assistant.

In a possible embodiment, testing the functionality of the extracted motherboard includes at least one communication modem.

The presence of said at least one communication modem is optional and is not needed when repurposing the motherboard for assembling an embedded computer system, for instance when the motherboard to repurpose originally comes from a smartphone and/or the embedded computer system to assemble being intended to be for a smartphone.

In a possible embodiment, the motherboard communication interface comprises at least one of a wired connection, an USB port, an Ethernet port, a serial interface or a Universal Asynchronous Receiver-Transmitter, UART.

In a possible embodiment, the standardized communication interface supports communication protocols selected from UART, USB, CAN, Wi-Fi, or 4G LTE.

In an embodiment, the method further comprises:
- preceding the extraction step of the motherboard from the electronic device, a step of pre-testing a component of the motherboard to be subsequently extracted, said component including at least one central processing unit and one motherboard interface of the extracted motherboard; and/or
following the extraction step of the motherboard from the electronic device, a step of testing a component of the extracted motherboard, said component including at least one central processing unit and one motherboard interface of the extracted motherboard.
In a possible embodiment, the pre-testing step and/or the testing step further comprises testing components present on or in the motherboard, including a memory or a peripheral connection, using diagnostic equipment.

This enables flexible verifications of the functionalities of the extracted motherboard before repurposing, if not all its functionalities, ensuring that the embedded computer system which will contain the repurposed motherboard will perform optimally.

In an embodiment, the method further comprises, after the extraction step and prior to the step of direct mechanical and electrical connection, connecting mechanically and electrically an adaptation board to the extracted motherboard and to the carrier board, the providing step being carried out with the carrier board and the adaptation board, the adaptation board being configured to adapt the motherboard interface between the carrier board and the extracted motherboard, said adapted motherboard interface subsequently enabling, during the providing step, the external communication of the extracted motherboard with modules external to the extracted motherboard.

Herein, the adaptation board comprises connectors which are electrically and mechanically configured to correspondingly connect to respective connectors of the extracted motherboard.

Herein or in a possible embodiment, the adaptation, by the adaptation board of the interface or data communication between the extracted motherboard and the carrier board, comprises a (re-)routing of the electrical signals from the extracted motherboard to the carrier board through one or more connectors, for instance a standard mezzanine connector , such as a standard COM Express connector.

This enables the communication with the external modules to be enabled thanks, in part or completely, to the use of the adaptation board. This also enables to implement, over a large number of times, the method for repurposing a motherboard, in order to assemble a large number of embedded computer systems in a short amount of time. Specifically, the use of an adaptation board allows for carrying out the method independently from the size of the batch of motherboards to repurpose and can further be adapted more easily to their dimensions and contents.

In a possible embodiment, this external communication can be enabled entirely thanks to the adaptation board.

In a possible embodiment, the extracting step comprises at least one of the sub-steps:
- replacing an operating system initially installed on the extracted motherboard by another operating system, said other operating system being distinct from the operating system initially installed on the extracted motherboard, and/or
- controlling boot processes and startup of the extracted motherboard through boot management components.

This enables a complete control over the functionality of the repurposed motherboard, allowing it to be used in any embedded system, free from constraints of the original operating system of the initial electronic device from which the motherboard comes from.

Herein, two operating systems are said to be different if they employ distinct kernels, system libraries, drivers, or user interface elements. For instance, even though an operating system such as Android shares a similar Linux kernel architecture with another operating system such as AOSP (Android Open-Source Project), replacing one entirely with the other implies that the user environment, hardware driver support, package management, and system-level APIs are substantially different, leading to distinct device performance, user experience, and system behavior. For smartphone motherboards, such differences may involve compatibility with baseband modems and communication protocols specific to 4G LTE networks.

Herein, boot processes are processes that initiate the loading and execution of the operating system, typically involving hardware checks, initial device setup, and launching of the operating system's kernel. For 4G LTE smartphones, these processes often involve the initialization of cellular modem firmware, SIM authentication, and ensuring proper communication between the modem processor and the application processor. These processes may include steps similar to POST (Power-On Self-Test), initializing the bootloader, and loading the OS image into RAM.

In a possible embodiment, boot management components comprise at least one of bootloaders (e.g., U-Boot, Little Kernel), custom firmware interfaces used for embedded mobile devices, or dedicated startup scripts for device-specific configurations such as radio firmware setup, baseband initialization, or network stack optimizations required for 4G LTE communication.

In an embodiment, the extracting step comprises at least one of the sub-steps:
- replacing an operating system initially installed on the extracted motherboard with another operating system, said other operating system being distinct from the operating system initially installed on the extracted motherboard; and/or
- controlling boot processes and startup of the extracted motherboard through boot management components.

In an embodiment, the provided at least one standardized interface enables the external communication of the extracted motherboard and/or the repurposed motherboard to be carried out via UART, USB, Bluetooth, Wi-Fi, a 4G network, a 4G LTE network, or a 5G network.

This enables the availability of a communication interface, and specifically, of at least one serial communication interface like UART or USB, which has a higher priority over cellular communication interfaces, whereas reprogramming and testing can be carried out via serial communication.

In an embodiment, the step of directly connecting mechanically and electrically the extracted motherboard to a carrier board is carried out without an intermediary socket.

This enables an efficient integration between the motherboard and carrier board, bypassing the need for dedicated sockets, simplifying hardware requirements, and reducing costs.

In an embodiment, the extracting step further comprises at least one of the sub-steps:
- disassembling the electronic device using mechanical tools; and/or
- assessing the reusability of the motherboard using at least one diagnostic module.

Still in order to overcome the aforementioned drawbacks, it is provided in another aspect a carrier board for use with a motherboard to repurpose, comprising:
- electrical power circuitry for providing electrical power to the motherboard,
- a direct mechanical and electrical connection interface for enabling connection to the motherboard, and
- an adaptation module configured to provide at least one standardized interface to the motherboard interface of the motherboard by adapting the motherboard interface into the standardized communication interface.

In a possible embodiment, the carrier board comprises communication interfaces which include support for external communications and data exchange, would it be via wired or wireless means, such as Wi-Fi and/or Bluetooth circuits integrated into the carrier board.

In a possible embodiment, the motherboard is a repurposed motherboard, or a motherboard intended for repurposing, e.g., a motherboard intended for assembling an embedded computer system, the motherboard being extracted from an electronic device.

In a possible embodiment, the carrier board further comprises connectors for integrating modules selected from displays, cameras, or sensors to support specific end-use applications.

In a possible embodiment, the carrier board is configured to enable the motherboard, when said motherboard is mechanically and electrically connected to the carrier board, to activate and/or control components connected to the motherboard, said components comprising modules selected from displays, cameras, sensors and/or wireless communication interfaces.

In a possible embodiment, the wireless communication interfaces which are activable and/or controllable by the carrier board when said motherboard is mechanically and electrically connected to the carrier board comprise Wi-Fi, 4G, 4G LTE, Bluetooth, UART, USB and/or Ethernet interfaces.

In an embodiment, the carrier board further comprises boot management components for managing startup processes of the motherboard.

This provides an efficient control of the repurposed motherboard's startup sequence, allowing it to be integrated into new systems seamlessly.

Still in order to overcome the aforementioned drawbacks, it is provided in another aspect an embedded computer system comprising:
- a repurposed motherboard, obtained by extracting a motherboard from an electronic device and providing the motherboard with at least one standardized power and communication interface, and
- a carrier board which is directly connected mechanically and electrically to the repurposed motherboard, the carrier board being configured to provide electrical power and at least one motherboard interface to the repurposed motherboard, wherein the communication interface of the repurposed motherboard comprises a standardized interface, said standardized interface enabling communication between the repurposed motherboard and electrical components that are external to the repurposed motherboard.

Herein, it is understood that the repurposed motherboard can have been extracted from an electronic device and subsequently processed, e.g., by carrying out the method described in the previous aspects and embodiments.

This enables the repurposed motherboard to functions as the primary processing unit of the embedded computer system

Herein, and like previously, external modules are modules located outside of the repurposed motherboard. In a possible embodiment, the embedded computer system can comprise these external modules, or these external modules can be located outside of the embedded computer system.

In various possible embodiments, the embedded computer system comprises at least one microprocessor or a microcontroller-based system, a memory and input/output (I/O) devices, all of which share a dedicated function within a larger system.

In various possible embodiments, the embedded computer system comprises additional modules selected among displays, cameras, or sensors.

Herein, and while embedded systems are computing systems, they can range from having no user interface, UI, for example, on devices designed to perform a single task, to complex graphical user interfaces, GUIs, such as in mobile devices. Uls can include buttons, light-emitting diodes, LEDs, and touchscreen sensing. Some systems use remote user interfaces as well.

In a possible embodiment, the standardized communication interface results from the adaptation of an initial motherboard communication interface to said standardized communication interface, said adaptation having been carried out by the carrier board, said carrier board being configured to modify a motherboard to which the carrier board is directly mechanically and electrically connected, by adapting the initial motherboard communication interface to said standardized communication interface.

In an embodiment, the embedded computer system further comprises an adaptation board which is connected mechanically and electrically to the repurposed motherboard and to the carrier board, the adaptation board being configured to adapt the motherboard interface between the repurposed motherboard and the carrier board so that the standardized communication interface is enabled by the adaptation board.

Herein, in this embodiment, when the adaptation board is electrically and mechanically connected to the motherboard, it can be understood that the adaptation board adapts electrical signals and routes them through one or more standard connector to the carrier board, enabling external communication of the motherboard and/or of the carried board through the standardized communication interface.

In an embodiment:
- the standardized communication interface is configured to enable external communication with external modules integrated on the carrier board or located in another electronic device, said other electronic device being configured to connect to the repurposed motherboard via Bluetooth, Wi-Fi, a 4G network, a 4G LTE network, or a 5G network, and/or
- the standardized communication interface comprises communication protocols selected from Bluetooth, Wi-Fi, 4G, 4G LTE, 5G, UART, USB, allowing data transmission and reception via the carrier board or via a 4G network, a 4G LTE network, or a 5G network.

In an embodiment, the embedded computer system is configured for integration into a computing cluster, with multiple repurposed motherboards connected with each other.

This enables relying on multiple repurposed motherboards for parallel processing.

In an embodiment, the communication interface is configured to route communications through USB ports on the repurposed motherboard, providing a standardized interface for input/output operations.

This enables a simplified and standardized way to connect external devices to the repurposed system, enhancing compatibility and ease of use.

Still in order to overcome the aforementioned drawbacks, it is provided in another aspect a kit or system for repurposing a motherboard to assemble an embedded computer system, the kit or system comprising a carrier board comprising electrical power circuitry for providing electrical power to the motherboard, a direct mechanical and electrical connection interface for enabling connection to the motherboard, an adaptation module configured to provide at least one standardized interface to a motherboard interface of the motherboard by adapting the motherboard interface into the standardized communication interface, and optionally, boot management components for managing startup processes of the motherboard; and a repurposed motherboard obtained by extracting a motherboard from an electronic device and providing the motherboard with at least one standardized power and communication interface, wherein the carrier board is configured to be directly connected mechanically and electrically to the repurposed motherboard such that the standardized communication interface of the repurposed motherboard enables communication between the repurposed motherboard and electrical components external to the repurposed motherboard.

In a possible embodiment, the adaptation module comprises the carrier board and/or the adaptation board, as described in the previous embodiments.

Still in order to overcome the aforementioned drawbacks, it is provided in another aspect using a motherboard for repurposing an embedded computer system according to the aforementioned embodiments, the embedded computer system being embedded in a discarded electronic device selected among a portable phone, an industrial monitoring application, a display screen for a vending machine, a home router, or an Internet-of-Things application, and wherein all external communication is routed through USB ports on the motherboard.

This enables a standardized interface for input/output operations, leading to optimal low-power and high efficiency features, thereby allowing for low-power computing and standard connectivity interfaces within the embedded computer system comprising the repurposed motherboard, and ensuring long-term operational performance.

### Brief description of the drawings

Other features, embodiments, definitions and advantages will become apparent upon reading the detailed description below and analyzing the attached drawings, including the following figures.
Figure 1 represents a motherboard according to an embodiment of the invention
Figure 2 represents a motherboard according to another embodiment of the invention.
Figure 3 represents a carrier board according to an embodiment of the invention
Figure 4 represents a flowchart of a method for repurposing a motherboard and assembling an embedded computer system with the motherboard.

Unless otherwise indicated, common or analogous elements in the figures are denoted by the same reference numerals and exhibit identical or analogous features, so that common or analogous elements are generally not described again for the sake of clarity and conciseness.

### Description of the embodiments

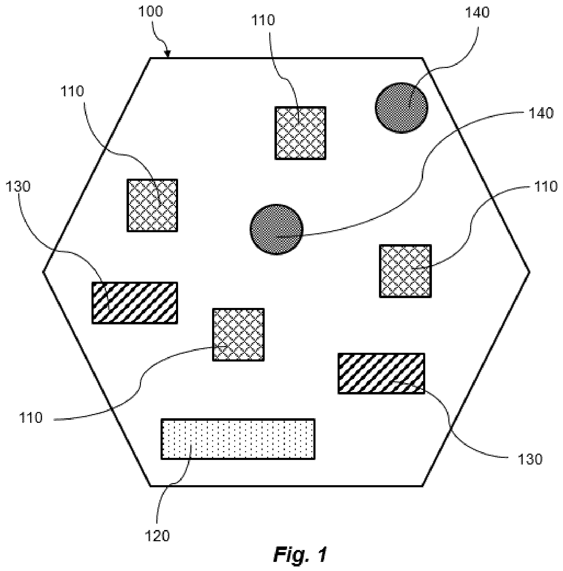

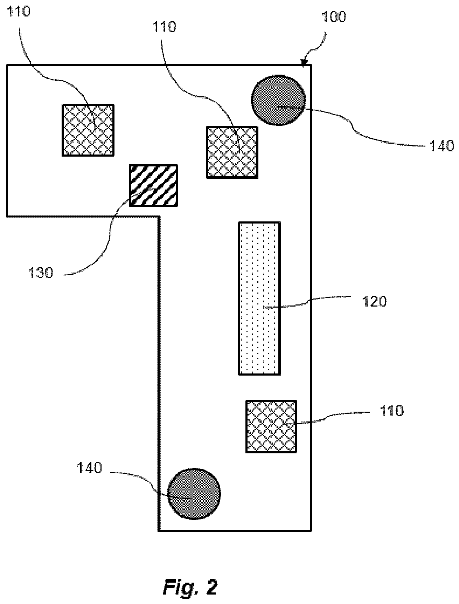

Figure 1 and Figure 2 each illustrates a motherboard according to a possible embodiment.

In particular, figure 1 shows a hexagonal motherboard 100, although this shape is not limiting. Figure 2 shows an L-shaped motherboard 100, which includes elements similar to those of the hexagonal motherboard 100. In both cases, the motherboard 100 has two opposite faces, where various elements are located on either of these faces.

In an embodiment, the motherboard 100 includes one or more connection points 110, also known as pins or pads, configured to establish electrical connectivity with external circuits or modules.

The motherboard 100 may also include different connectors 120, such as pin headers or Board-to-board connectors.

In an embodiment, the motherboard 100 integrates various integrated circuits 130, such as CPUs, GPUs, or modems for Bluetooth, Wi-Fi, or 4G LTE, thereby enabling processing and connectivity functions.

For secure mechanical integration into an embedded system, the motherboard 100 comprises one or more fixation elements 140, including female elements like fixation holes or male elements, which are appropriately positioned on one of these faces for reliable structural attachment.

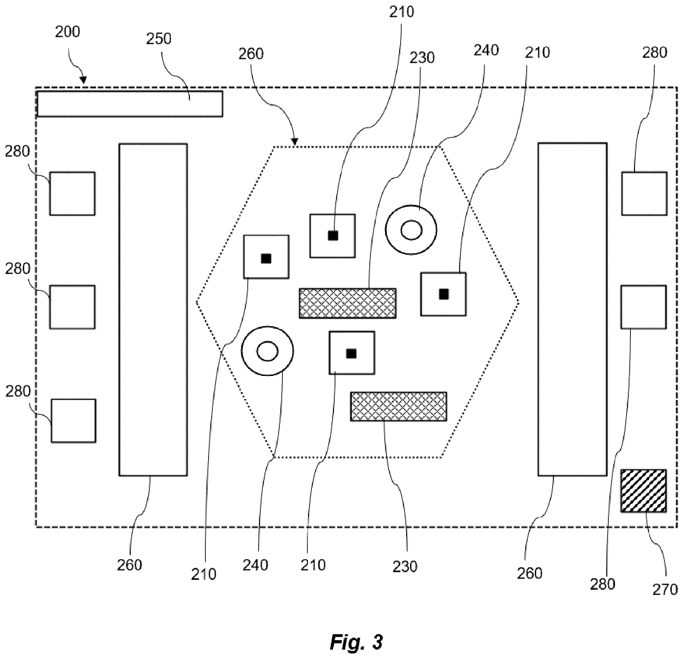

Figure 3 illustrates a carrier board 200 adapted to implement the invention according to one embodiment.

According to different embodiments, the carrier board 200 includes various additional features, which can be present individually or in combination:
- one or more fixation points 240, which may be male attachment elements like nuts or female attachment elements like holes, adapted to cooperate with at least one fixation element 140 on a specific motherboard 100,
- one or more connection points 210, specific to the carrier board 200 yet configured to interact with the connection points 110 on the motherboard 100, either through direct mechanical and electrical connection or through a cable if distance is involved,
- one or more connectors 230, specific to the carrier board 200 and configured to engage with the connectors 120 on the motherboard 100, which may connect directly or through a cable if the carrier board 200 and motherboard 100 are separated,
- one or more optional support electronics or extension electronics, analog or digital, adapted to a target application, providing power to the motherboard 100 when electrically or mechanically connected to the carrier board 200,
- at least one integrated or PCB-mounted antenna or external antenna connector 270 for remote communication with external devices if wireless communication like Bluetooth, Wi-Fi or 4G LTE is enabled, and/or
- a set of ports 280, such as specific connectors for power supply or communication, possibly in conjunction with antenna 270.

In an embodiment, the carrier board 200 is a PCB and includes a footprint 260 for the motherboard 100, here in a hexagonal shape, ensuring precise positioning in case of mechanical connection.

For instance, this footprint 260 provides designated attachment points that allow for precise alignment and stable mechanical connection. This structure facilitates secure positioning, preventing displacement of the motherboard 100 during operation.

In an embodiment, the motherboard 100 and/or the carrier board 200 may be configured to operate with reprogrammed operating systems, providing full control and flexibility over repurposed hardware and enabling new functionalities.

One advantage is the adaptability of these reused motherboards, without the need for specific hardware modifications or specialized sockets, supporting wider scalability for diverse embedded and standalone computing applications.

These features enable the reuse of functional electronic components of discarded devices like smartphone motherboards, offering a more sustainable solution compared to standard recycling methods, which consume energy to extract raw materials.

These features also enable an efficient repurposing and reuse of motherboards with specific shapes, connection points, and integrated circuits in embedded systems and offers power, communication, and structural support tailored to the requirements of the motherboard 100 and/or of the carrier board 200 when used within an embedded system, allowing for standardized connectivity like Wi-Fi, USB, or ethernet.

In an embodiment, the carrier board 200 includes boot management components for controlling and managing the startup processes of the motherboard 100. These components ensure that the motherboard 100 follows specific boot sequences compatible with a variety of operating systems or custom software configurations. This enables controlled and predictable initialization.

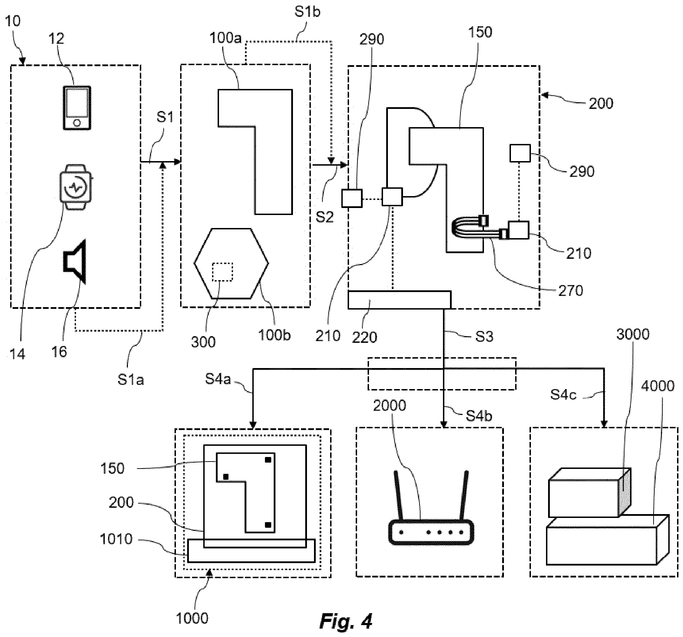

Figure 4 illustrates the flowchart of a method for repurposing a motherboard, with a view of assembling the repurposed motherboard within an embedded computer system.

As shown, in an embodiment, it is proposed to implement the disassembly of electronic devices 10, such as a smartphone 10, a smartwatch 14, or a Bluetooth speaker 16, to allow the extraction S1 of a motherboard 100 from these devices.

The motherboard 100, once extracted from such source devices, can retain the core electronics of the original device, including key processing and communication components, which are configured to operate independently of the source device.

In an embodiment, this provides a motherboard separated from the other electrical components present in the devices 10, for example, an L-shaped motherboard 100a or a hexagonal-shaped motherboard 100b.

Once separated, the form factor of the motherboard 100, which can vary depending on the original source device, may include standardized layouts, facilitating adaptable reconnection with other components in a target device.

With this extracted motherboard, a connection step S2 can be implemented to attach this motherboard 100a (or 100b) to a carrier board 200. This connection step S2 can be performed mechanically, through direct contact, or by connecting the motherboard 100 to one or more components of the carrier board 200.

In an embodiment, during the connection step S2, or during the subsequent step S3, with step S3 potentially implemented simultaneously with step S2, a connection of the motherboard 100 to the carrier board 200 can be established using a ribbon or cable 270, with this ribbon or cable 270 thereby linking the motherboard 100, or the motherboard 150 after step S2, to an electronic circuit 210 of the carrier board 200. Optionally, the electronic circuit 210 of the carrier board 200 is itself connected to a connector 290 on the carrier board 200, with this connector 290 potentially being a terminal. The motherboard can also be directly connected to said connector 290, or to an external connector (not represented).

The use of ribbons, cables or similar modular connectors allows flexible electrical connections between the motherboard 100 and carrier board 200, enabling efficient communication between the core electronics and additional circuits provided on the carrier board 200.

In an embodiment, on or within a part of the carrier board 200, a board edge connector 220 may be provided, this board edge connector 220 being connected to another possible electronic circuit 210 or directly to the motherboard 150 (not depicted). Optionally, this other electronic circuit 210 of the carrier board 200 is not only connected to the board edge connector 220 but can also be connected to another connector 290 on the carrier board 200, which may, for example, be a port. In all cases, this other electronic circuit 210 allows for an interface between the motherboard, represented by element 150 once repurposed, and the board edge connector 220. Specifically, this provides a repurposed motherboard 150 to which at least one standardized interface is provided, enabling communication with external components.

This arrangement enables the repurposed motherboard 150 to interface with various electronic modules or connectors conforming to standardized protocols, such as USB or PCI, ensuring compatibility with a wide range of external devices.

This also enables preparing the development of a circular microcomputer, wherein a discarded motherboard from an electronic device becomes central to a new system, being reprogrammed and connected to an "extension board" that offers essential connectivity and processing capabilities. This extension board, which is the carrier board 200, then integrates various standardized interfaces such as 4G LTE, Wi-Fi, USB, or Ethernet, enabling broad applicability for the repurposed device.

Through these standardized interfaces, the repurposed motherboard 150 can function as a central computing unit for embedded systems that require remote connectivity, data processing, or multimedia streaming and/or display capabilities.

In an embodiment, during step S3, the motherboard 100 is converted or transformed into a repurposed motherboard 150 in the following way: one or more standardized interfaces are installed on the motherboard 100, with this interface enabling appropriate interfaces of the motherboard to become a standardized power or communication interfaces, which itself allows external communication of the extracted motherboard with external electrical components. The extracted motherboard, once it supports this standardized power and communication interface, is then referred to as a repurposed motherboard.

For example, the repurposing process may involve installing a compatible socket or edge connector that matches industry standards, allowing efficient transfer of power and data to external peripherals.

At the end of step S3, the motherboard 100 can be considered as being repurposed and corresponds to the repurposed motherboard 150 as shown. Once step S3 of providing at least one standardized interface to the extracted motherboard 100 is completed, transforming it into a repurposed motherboard 150, it is possible to implement one or more of steps S4a, S4b, and/or S4c, which involve integrating the repurposed motherboard with the carrier board 200. This modular approach allows the repurposed motherboard 150 to serve as an independent computing unit or be integrated as part of a more extensive system configuration.

In one example, assembling the repurposed motherboard 150 and the carrier board 200 can be performed by integrating them, in step S4a, into a host application board 1000, also known as a target application board. For instance, assembling the repurposed motherboard 150 and the carrier board 1000 can also be performed by integrating them, in step S4a, with an adaptation board that serves as an intermediary.

After step S4a, the host application board 1000 then includes the repurposed motherboard 150 and the carrier board 200, connected to the host application board 1000 via a standardized connector 1010 such as a Smart Mobility Architecture, SMARC, connector, which is a specific Computer-on-Module, COM standard with 314 pins. The standardized connector 1010 is similar to the board edge connector 220 which has been previously described. Such connectors integrate serial communication like USB, ethernet or SPI, display or camera signal lines, allowing to provide on a single standardized connector multiple valuable signals dispersed on the motherboard.

This modular approach allows the repurposed motherboard to serve as an independent computing unit or be integrated as part of a more extensive system configuration.

In another example, assembling the repurposed motherboard 150 and the carrier board 200 can be performed by integrating them, in step S4b, into an internet router 2000, provided such dedicated embedded computing system has been designed to host the appropriate communication interfaces like DSL, ethernet and Wi-Fi and is implementing the appropriate software functionality like routing and firewall.

In yet another example, assembling the repurposed motherboard 150 and the carrier board 200 can be performed by integrating them, in step S4c, into an industrial computer 3000 and/or into an electrical enclosure 4000, with the industrial computer 3000 and the electrical cabinet 4000 potentially being interconnected.

This provides a compact, modular embedded system, where the repurposed smartphone motherboard 150 serves as the central processing unit, managing connectivity and data processing via the carrier board 200. The final embedded system is capable of supporting modular expansion through standardized interfaces, thereby enhancing the operational versatility of the system.

In an embodiment, an embedded computer system such as a host application board 1000, an internet router 2000, an industrial computer 3000 and/or an electrical enclosure 4000 comprising the repurposed motherboard 150 also then typically comprises a standardized communication interface configured to enable interaction with external modules. Such external modules may be integrated on the carrier board 200 or located in another electronic device. Connectivity through multiple network types can be supported, such as 4G, 4G LTE, or 5G networks, facilitating long-range and remote communication. This enables the repurposed motherboard 150 to interact seamlessly with distant devices or control systems, allowing data exchange across diverse embedded applications.

In an embodiment, the standardized communication interface includes protocols selected from Wi-Fi, 4G, 4G LTE, 5G, UART, and USB, supporting data transmission and reception either directly via the carrier board or through broader network connections. For instance, internet data can come either from carrier board terminals or from a wireless interface.

In an embodiment, the embedded computer system 1000 is designed for integration into a computing cluster by interconnecting multiple repurposed motherboards 150. This configuration enables a scalable system where multiple repurposed motherboards 150 can work in parallel, allowing for distributed computing tasks and increased processing power. This enables the system to handle more complex workloads by leveraging the combined computational capacity of each repurposed motherboard 150. Such an arrangement is advantageous for high-performance computing applications, where resources can be dynamically allocated across the interconnected motherboards.

In an embodiment, the method further comprises a pre-testing step S1a, which is conducted before or during the extraction step S1 of the motherboard 100 from the electronic device 10. This pre-testing step S1a optionally involves checking a component of the motherboard 100, particularly the central processing unit 110 and one motherboard interface. This enables verifying, before carrying out further steps, the functionality of key elements such as the CPU 110 before the motherboard 100 is repurposed, reducing the risk of integrating defective components into the target embedded computer system.

In an embodiment, after the motherboard 100 is extracted in step S1, and preferably before the connecting step S2, a post-extraction testing step S1b is carried out to check the performance of the extracted motherboard 100. This step involves testing the central processing unit 110 and one or more motherboard interfaces to ensure that no damage occurred during the extraction. This arrangement allows early identification of any issues related to components of the motherboard 100, later enabling smooth integration into an embedded system by eliminating faulty components that could otherwise compromise its functioning.

In an embodiment, the pre-testing step S1a and/or post-testing step S1b involve(s) diagnostic procedures that can include software-based tests or hardware signal integrity checks to evaluate the motherboard interface and central processing unit.

For example, such testing steps can confirm that the CPU 110 executes instructions correctly and that the motherboard interface is capable of transmitting and receiving data. This ensures that the extracted motherboard 100, once repurposed as motherboard 150, is fully functional and compatible with the carrier board 200 or any other embedded system component.

In an embodiment, after the extraction step S1 of the motherboard 100, and prior to the direct mechanical and electrical connection step S2 to the carrier board 200, an adaptation board can be connected to the extracted motherboard 100 and to the carrier board 200 during the step S1a. This adaptation board serves to bridge possible differences in the motherboard interface between the extracted motherboard 100 and the carrier board 200. For example, when a SMARC connector is used, the adaptation board may adjust the voltage levels, signal formats, or connector types between the two boards, allowing the extracted motherboard 100 to seamlessly integrate with the carrier board 200. This enables compatibility even when the original design of the extracted motherboard 100 does not match the carrier board's interface standards.

In this embodiment, when an adaptation board is used, the adaptation board functions during the providing step S3 in coordination with the carrier board 200 to adapt the motherboard interface. This adaptation may involve converting communication protocols or electrical signals.

For instance, if the motherboard 100 was originally designed for a specific proprietary interface, the adaptation board can be configured to convert the communication protocols or electrical signals to a standardized protocol such as PCIe or USB, allowing external devices to interact with the repurposed motherboard 150.

In an embodiment, the provided standardized interface enables external communication of the extracted motherboard 100 or repurposed motherboard 150 over various network protocols, such as 4G, 4G LTE, or 5G networks. This arrangement facilitates remote connectivity for the embedded systems 1000, 2000, 3000 or 4000 after steps S4a, S4b or S4c, enabling transmission and reception of data from external sources through widely accessible networks. For example, when the motherboard 150 is incorporated into a device requiring real-time data, such as a web browsing, this capability enables accessing high-speed data channels such as live data streaming.

In an embodiment, the extracting step S1 includes replacing the operating system initially installed on the extracted motherboard 100 with another operating system 300, which is distinct from the original system. This replacement can be necessary when the intended application of the repurposed motherboard 150 requires different software capabilities, access rights, compatibility, or security standards than those offered by the original operating system. For example, replacing a proprietary OS with a lightweight Linux-based system 300 can enhance resource efficiency, allowing the motherboard to perform better in an embedded system 1000-4000 comprising a repurposed motherboard 150.

In an embodiment, during extraction step S1, boot processes and startup procedures of the extracted motherboard 100 are controlled through boot management components. These components enable adjusting the startup sequence or loading parameters, ensuring compatibility with the new operating environment or carrier board 200. For example, a boot manager might delay certain processes to allow proper initialization of connected peripherals or prioritize loading of essential applications.

In an embodiment, step S2 of directly connecting the extracted motherboard 100 to the carrier board 200 is performed without using an intermediary socket, ensuring a more streamlined and compact physical connection. This configuration reduces mechanical complexity, contributing to improved reliability and ease of assembly, as fewer components are involved in the connection setup, making the integration of the repurposed motherboard 150 more efficient and robust in embedded systems.

In an embodiment, the extracting step S1 includes disassembling the electronic device 10 using mechanical tools (not represented). Preferably, a machine tool is configured to carefully open the housing of the electronic device 10 and to remove one or more of its internal components to access the motherboard 100. Mechanical tools such as screwdrivers or prying tools facilitate controlled disassembly, ensuring the preservation of the motherboard 100 for future use.

In another embodiment, the extracting step S1 or any of the pre-testing and post-testing steps S1a/S1b comprises assessing the reusability of the motherboard 100 using at least one diagnostic module (not represented). This diagnostic module evaluates the functionality of key components, verifying that the motherboard 100 operates within expected parameters, such as predetermined electrical power consumption.

In other embodiments that are not illustrated, additional advantages can be obtained by repurposing modular components to improve or expand existing systems. Individual components like a GPS chipset, processor, or display, extracted as part of step S1, may be integrated into a mainboard of a computing device. This integration, which is preferably carried out in step S3, allows supplementary features from the repurposed device to enhance the host device, such as enabling GPS or touch-screen functionality within a computer.

In other embodiments that are not illustrated, the communication interface of various embedded computer systems can be configured to route communications through USB ports on multiple repurposed motherboards. The routing of communications through USB ports on these repurposed motherboards 150 allows for streamlined data flow across the interconnected components within a computing cluster. This arrangement can also support efficient data sharing and coordination between individual motherboards, enhancing the overall functionality of the computing cluster. By using standardized protocols, such as USB protocols, one can achieve high-speed data transfer and ensure compatibility with widely available hardware, which is beneficial for building flexible, high-performance computing clusters in various embedded or industrial applications.

For creating distributed or mesh computing systems, multiple motherboards extracted from various devices are added to a target mainboard, a target mainboard being a printed circuit board, PCB, in a given computing device, such as that of a server, to create a single unified, virtual processing unit distributing processing tasks across multiple Central Processing Units. This mesh arrangement uses the modularity of multiple repurposed motherboards 150 to configure them as part of a parallel processing cluster, enabling efficient resource utilization and high-performance computing without the need for specialized, high-cost processors.

Although the present disclosure and the embodiments described therein have been shown and described with reference to specific preferred embodiments, this is not to be construed as limiting the invention itself. Various changes may be made in form and details without departing from the scope of the invention as defined by the appended claims.

## Claims

1. A method for repurposing a motherboard (100) to assemble an embedded computer system (1000, 2000, 3000, 4000), the method comprising the steps of:
- (S1) extracting the motherboard (100) from an electronic device (10 ; 12, 14, 16);
- (S2) directly connecting mechanically and electrically the extracted motherboard (100) to a carrier board (200), wherein the carrier board (200) provides electrical power and at least one motherboard interface to the extracted motherboard (100),
- (S3) providing, with the carrier board (200), to the extracted motherboard (100), at least one standardized interface, said at least one standardized interface being configured to adapt the at least one motherboard interface into a standardized power and communication interface, said standardized power and communication interface enabling an external communication of the extracted motherboard (100) to electrical components that are external to the extracted motherboard (100), the extracted motherboard (100) comprising the standardized power and communication interface being called repurposed motherboard (150), and
- (S4a, S4b, S4c) assembling the embedded computer system (1000, 2000, 3000, 4000) by integrating the repurposed motherboard (150) and the carrier board (200) into said embedded computer system (1000, 2000, 3000, 4000).

2. The method according to claim 1, further comprising:
- preceding the extraction step (S1) of the motherboard (100) from the electronic device (10 ; 12, 14, 16), a step of pre-testing (S1a) a component of the motherboard (100) to be subsequently extracted, said component including at least one central processing unit (110) and one motherboard interface of the extracted motherboard (100), and/or
- following the extraction step (S1) of the motherboard (100) from the electronic device (10 ; 12, 14, 16), a step of testing (S1b) a component of the extracted motherboard (100), said component including at least one central processing unit (110) and one motherboard interface of the extracted motherboard (100).

3. The method according to claim 1 or 2, further comprising, after the extraction step (S1) and prior to the step of direct mechanical and electrical connection (S2), connecting mechanically and electrically an adaptation board to the extracted motherboard (100) and to the carrier board (200), the providing step (S3) being carried out with the carrier board (200) and the adaptation board (...), the adaptation board being configured to adapt the motherboard interface between the carrier board (200) and the extracted motherboard (100), said adapted motherboard interface (subsequently enabling, during the providing step (S3), the external communication of the extracted motherboard (100) with the modules which are external to the extracted motherboard.

4. The method according to any of the preceding claims, wherein the provided at least one standardized interface enables the external communication of the extracted motherboard (100) and/or of the repurposed motherboard (150) to be carried out via UART, USB, Bluetooth, Wi-Fi, a 4G network, a 4G LTE network or a 5G network.

5. The method according to any of the preceding claims, wherein the extracting step (S1) comprises at least one of the sub-steps:
- replacing an operating system initially installed on the extracted motherboard (100) with another operating system (300), said other operating system being distinct from the operating system initially installed on the extracted motherboard (100), and/or
- controlling boot processes and startup of the extracted motherboard (100) through boot management components.

6. The method according to any of the preceding claims, wherein the step (S2) of directly connecting mechanically and electrically the extracted motherboard (100) to a carrier board (200) is carried out without an intermediary socket.

7. The method according to claim 1, wherein the extracting step (S1) further comprises at least one of the sub-steps:
- disassembling the electronic device using mechanical tools; and/or
- assessing the reusability of the motherboard (100) using at least one diagnostic module.

8. A carrier board (200) for use with a motherboard (100) to repurpose, comprising:
- electrical power circuitry for providing electrical power to the motherboard (100);
- a direct mechanical and electrical connection interface for enabling connection to the motherboard (100), and
- an adaptation module configured to provide at least one standardized interface to the motherboard interface of the motherboard (100) by adapting the motherboard interface into the standardized communication interface.

9. The carrier board (200) according to claim 8, further comprising boot management components for managing startup processes of the motherboard (100).

10. An embedded computer system (1000, 2000, 3000, 4000) comprising:
- a repurposed motherboard (150), obtained by extracting a motherboard (100) from an electronic device (10; 12, 14, 16) and providing the motherboard with at least one standardized power and communication interface, and
- a carrier board (200) which is directly connected mechanically and electrically to the repurposed motherboard (150), the carrier board being configured to provide electrical power and at least one motherboard interface to the repurposed motherboard (150),
wherein the communication interface of the repurposed motherboard (150) comprises a standardized interface, said standardized interface enabling communication between the repurposed motherboard (150) and electrical components that are external to the repurposed motherboard (150).

11. The embedded computer system (1000, 2000, 3000, 4000) according to claim 10, further comprising an adaptation board which is connected mechanically and electrically to the repurposed motherboard (150) and to the carrier board (200), the adaptation board being configured to adapt the motherboard interface between the repurposed motherboard (150) and the carrier board (200) so that the standardized communication interface is enabled by the adaptation board.

12. The embedded computer system (1000, 2000, 3000, 4000) according to claim 10 or 11, wherein:
- the standardized communication interface is configured to enable communication with external modules integrated on the carrier board (200) or located in another electronic device, said other electronic device being configured to connect to the repurposed motherboard (150) via Bluetooth, Wi-Fi, a 4G network, a 4G LTE network, or a 5G network, and/or
- wherein the standardized communication interface comprises communication protocols selected from Bluetooth, Wi-Fi, 4G, 4G LTE, 5G, UART, USB, allowing data transmission and reception via the carrier board or via a 4G network, a 4G LTE network, or a 5G network.

13. The embedded computer system (1000, 2000, 3000, 4000) according to any one of claims 10 to 12, which is configured for integration into a computing cluster, with multiple repurposed motherboards (150) connected with each other.

14. The embedded computer system (1000, 2000, 3000, 4000) according to any one of claims 10 to 13, wherein the communication interface is configured to route communications through USB ports on the repurposed motherboard (150), providing a standardized interface for input/output operations.

15. Use of a motherboard (100) for repurposing an embedded computer system (1000, 2000, 3000, 4000) according to any of claims 10 to 14, the embedded computer system (1000, 2000, 3000, 4000) being embedded in a discarded electronic device selected among a portable phone, an industrial application or an Internet-of-Things, loT, application, and wherein all external communication is routed through USB ports on the motherboard (100).
